# EUROPEAN PATENT SPECIFICATION

(11) **EP 3 372 400 B1**
(45) Date of publication and mention of the grant of the patent: **07.08.2024**
(21) Application number: 16861994.8
(22) Date of filing: 27.10.2016
(51) Int. Cl.: H10K 30/80, H10K 50/00, H05B 33/22, H05B 33/28, B32B 15/08, H01B 5/14

(54) **FILM FOR TRANSPARENT CONDUCTIVE LAYER LAMINATION, METHOD FOR PRODUCING SAME, AND TRANSPARENT CONDUCTIVE FILM**
FOLIE FÜR TRANSPARENTE LEITFÄHIGE SCHICHTKASCHIERUNG, VERFAHREN ZU DEREN HERSTELLUNG SOWIE TRANSPARENTE LEITFÄHIGE FOLIE
FILM POUR STRATIFICATION DE COUCHE CONDUCTRICE TRANSPARENTE, PROCÉDÉ POUR SA PRODUCTION, ET FILM CONDUCTEUR TRANSPARENT

(30) Priority: 06.11.2015 JP 2015218292
(43) Date of publication of application: 12.09.2018
(73) Proprietor: Lintec Corporation, Tokyo 173-0001 (JP)
(72) Inventor: MORITA, Wataru, Tokyo 173-0001 (JP); HARA, Tsutomu, Tokyo 173-0001 (JP); MUTOU, Tsuyoshi, Tokyo 173-0001 (JP); KONDO, Takeshi, Tokyo 173-0001 (JP)
(74) Representative: Gille Hrabal Partnerschaftsgesellschaft mbB Patentanwälte
(86) International application number: PCT/JP2016/081830
(87) International publication number: WO 2017/077933

(56) References cited:
- EP-A1- 1 388 836
- WO-A1-2013/128932
- WO-A1-2014/129390
- JP-A- 2009 140 750
- JP-A- 2010 129 379
- JP-A- 2011 515 003
- JP-A- 2014 216 175
- JP-A- 2014 216 175
- JP-A- 2015 176 465
- US-A1- 2006 134 431
- DATABASE WPI Week 201361, Derwent World Patents Index; AN 2013-N06659
- DATABASE WPI Week 201478, Derwent World Patents Index; AN 2014-U44619

## Description

### Technical Field

The present invention relates to a film for transparent conductive layer lamination, a method for producing the film, and a transparent conductive film as defined in the claims.

### Background Art

Recently, with development of printed electronics, large-area and additionally flexible electronic devices mainly using an organic material are being developed, typically including organic thin-film solar cells, organic EL illuminations and others that are expected to grow popular in future. From the viewpoint of attaining high-efficiency and large-area electronic devices, the transparent conductive film to be used as the translucent electrode in such electronic devices is desired to be such that the surface resistance of the transparent conductive layer is reduced for the purpose of lowering power loss or improving characteristics distribution to be caused by the transparent conductive layer generally having a high electric resistivity in device operation (power collection or voltage application). To meet the requirement, a structure having, as an auxiliary electrode layer for the transparent electrode layer, a pattern layer of a metal thin line or a metal paste having a lower resistance value than that of the transparent conductive layer is used.

In the above-mentioned structure, for example, where the transparent conductive layer is laminated on the auxiliary electrode layer, there may occur a height difference in accordance with the thickness of the auxiliary electrode layer, and finally the height difference may further have some influence on the conductive site of the active layer (drive layer, etc.) of neighboring devices and others, therefore often causing factors of degradation of device properties, occurrence of failure owing to short circuit or the like, and reduction in device lifetime.

As a method for solving the problem, PTL 1 discloses use of a transparent resin layer using a thermosetting polyester resin or a UV-curable acrylate resin between the transparent electrode layer and the auxiliary electrode layer. PTL 2 discloses a production method with, as introduced thereinto, a process that a face composed of an auxiliary electrode layer and a transparent resin layer provided in an opening can reflect smoothness of a transfer substrate, in which the face kept in contact with the transparent conductive layer can have higher smoothness than in PTL 1.

### Citation List

### Patent Literature

PTL 1: JP-2005-332705A
PTL 2: JP-2014-216175A
PTL 3: EP 1 388 836 A1
PTL 4: WO 2013/128932 A1
PTL 5: WO 2014/129390 A1

### Summary of Invention

### Technical Problem

However, in PTL 1, the transparent resin layer receives mechanical deformation and damage owing to heat history in lamination with indium-tin oxide (ITO) to lose smoothness, and as a result, the above-mentioned conventional problems could not as yet be solved.

In PTL 2, the smoothness is better than in PTL 1, but the heat resistance is not as yet sufficient, and therefore the same problems as in PTL 1 still remain as such.

PTL 3, PTL 4, PTL 5 all disclose further prior art transparent resin layers.

In consideration of the above-mentioned problems, an object of the present invention is to provide a film for transparent conductive layer lamination having high heat resistance and excellent in smoothness of the surface including an auxiliary electrode layer, a method for producing the film, and a transparent conductive film having a low surface resistivity and protected from occurrence of device characteristic failure and from reduction in device lifetime owing to short circuit between electrodes in a device.

### Solution to Problem

The present inventors have assiduously studied for the purpose of solving the above-mentioned problems and, as a result, have found that, in a film for transparent conductive layer lamination including a transparent resin film substrate having laminated thereon a composite layer which at least includes a transparent resin layer A, a metal layer having an opening, and a transparent resin layer B containing inorganic fine particles provided in the opening, increase in the surface roughness of the face of the metal layer having an opening and the transparent resin layer B containing inorganic fine particles provided in the opening of the composite layer is suppressed in the heat history in subsequent lamination with a transparent electrode layer, and have completed the present invention.

Specifically, the present invention is disclosed in the claims.

### Advantageous Effects of Invention

According to the present invention, there can be provided a film for transparent conductive layer lamination having high heat resistance and excellent in smoothness of the surface including an auxiliary electrode layer, a method for producing the film, and a transparent conductive film having a low surface resistivity and protected from occurrence of device characteristic failure and from reduction in device lifetime owing to short circuit between electrodes in a device.

### Brief Description of Drawings

Fig. 1 is a cross-sectional view showing one example of a film for transparent conductive layer lamination and a transparent conductive film of the present invention.
Fig. 2 is an explanatory view showing one process example of the production method of the present invention in order of process steps.

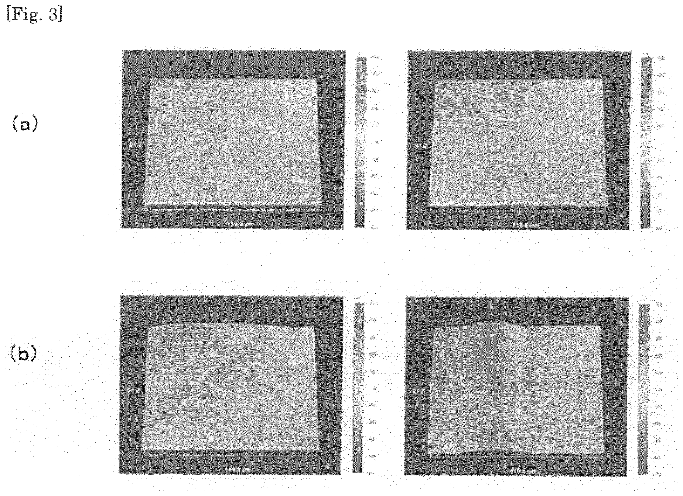

Fig. 3 shows a surface of the composite layer of a film for transparent conductive layer lamination obtained in Examples of the present invention, and a surface of a transparent conductive film after lamination of a transparent conductive layer on the surface, in which (a) is an optical interference image of Example 1 (the left is before lamination, the right is after lamination, measurement range: 91 µm × 120 µm), (b) is an optical interference image of Comparative Example 1 (the left is before lamination, the right is after lamination, measurement range: 91 µm × 120 µm).

### Description of Embodiments

### [Film for Transparent Conductive Layer Lamination]

The film for transparent conductive layer lamination of the present invention is a film for transparent conductive layer lamination including a transparent resin film substrate having laminated thereon a composite layer which at least includes a transparent resin layer A, a metal layer having an opening, and a transparent resin layer B containing inorganic fine silica particles provided in the opening, wherein the metal layer and the transparent resin layer B containing silica fine particles are exposed on the face of the composite layer on the side opposite to the face of the transparent resin film substrate side.

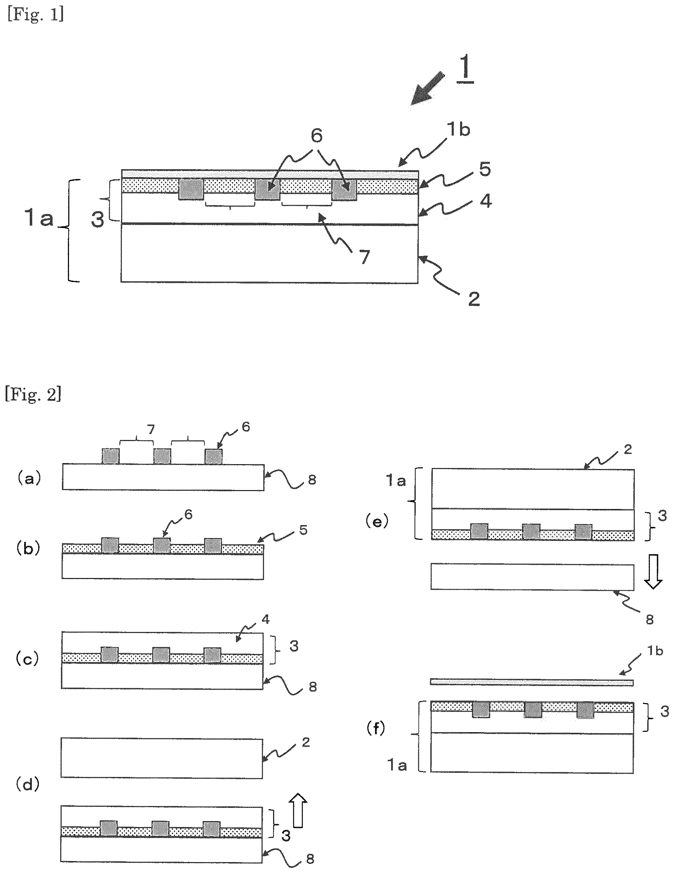

Fig. 1 is a cross-sectional view showing one example of a film for transparent conductive layer lamination and a transparent conductive film of the present invention. In Fig. 1, the film for transparent conductive layer lamination 1a has a composite layer 3 of at least a transparent resin layer A4, a metal layer 6 having an opening 7, and a transparent resin layer B5 containing silica fine particles provided in the opening, as laminated on a transparent resin film substrate 2.

The transparent resin layer B containing silica fine particles is arranged in the opening of the metal layer of the composite layer that constitute the film for transparent conductive layer lamination, via the transparent resin layer A on the transparent film substrate, and accordingly, when a transparent conductive layer is laminated on the film for transparent conductive layer laminate, peeling, cracking and surface profile worsening to be caused by mechanical interaction such as thermal shrinkage difference (including elasticity difference) between the composite layer and the transparent conductive layer owing to heat history in lamination can be prevented. Further, since the transparent resin layer B containing silica fine particles is arranged, the film for transparent conductive layer lamination can be protected from damages by laser light and etchant in laser etching and wet etching on the transparent conductive layer.

In addition, when a transparent conductive layer is laminated to give a transparent conductive film, the metal layer in the composite layer (hereinafter a patterned metal layer may be referred to as "auxiliary electrode layer") may lower the surface resistivity of the transparent conductive film (surface resistivity reduction).

### <Transparent Resin Layer B Containing Silica

### Fine Particles>

The transparent resin layer B containing silica fine particles (hereinafter may be referred to as "heat-resistant layer") for use in the present invention is, as described above, arranged in the opening of the metal layer of the composite layer of the film for transparent conductive layer lamination of the present invention. As having heat resistance, the layer is indispensably arranged for preventing increase in the surface roughness of the transparent conductive layer to be derived from the heat history in transparent conductive layer lamination.

The heat-resistant layer in the present invention is formed by curing an active energy ray-sensitive composition (P) mentioned below.

### (P) Active Energy Ray-Sensitive Composition

The active energy ray-sensitive composition contains (i) an active energy ray-curable compound, (ii) inorganic fine particles and (iii) a photopolymerization initiator. When irradiated with an active energy ray, the active energy ray-sensitive composition crosslinks and cures to form a heat-resistant layer.

Within a range not detracting from the advantageous effects of the present invention, the composition may contain additives such as a UV absorbent, a light stabilizer, an antioxidant, an IR absorbent, an antistatic agent, a leveling agent, a defoaming agent, etc.

In the present invention, "active energy ray" means electromagnetic waves such as UV rays, electron beams and the like or charged particle radiations having an energy quantum.

### (i) Active Energy Ray-Curable Compound

In the present invention, the "active energy ray-curable compound" means a polymerizable compound that may crosslink and cure in irradiation with the above-mentioned active energy rays.

The active energy ray-curable compound is preferably a polyfunctional (meth)acrylate monomer and/or (meth)acrylate prepolymer, and is more preferably a polyfunctional (meth)acrylate monomer.

In the present invention, (meth)acrylate means both acrylate and methacrylate, and the same shall apply to other analogous terms.

Examples of the polyfunctional (meth)acrylate monomer include 1,4-butanediol di(meth)acrylate, 1,6-hexanediol di(meth)acrylate, neopentyl glycol di(meth)acrylate, polyethylene glycol di(meth)acrylate, neopentyl glycol hydroxypivalate di(meth)acrylate, dicyclopentanyl di(meth)acrylate, caprolactone-modified dicyclopentenyl di(meth)acrylate, ethylene oxide-modified phosphate di(meth)acrylate, allylated cyclohexyl di(meth)acrylate, isocyanurate di(meth)acrylate, trimethylolpropane tri(meth)acrylate, dipentaerythritol tri(meth)acrylate, propionic acid-modified dipentaerythritol tri(meth)acrylate, pentaerythritol tri(meth)acrylate, propylene oxide-modified trimethylolpropane tri(meth)acrylate, tris(acryloxyethyl) isocyanurate, propionic acid-modified dipentaerythritol penta(meth)acrylate, dipentaerythritol hexa(meth)acrylate, caprolactone-modified dipentaerythritol hexa(meth)acrylate, etc.

One alone or two or more of these monomers may be used either singly or as combined.

Examples of the (meth)acrylate prepolymer include polyester (meth)acrylate prepolymers, epoxy(meth)acrylate prepolymers, urethane (meth)acrylate prepolymers, polyol (meth)acrylate prepolymers, etc.

Polyester (meth)acrylate polymers may be obtained, for example, by esterifying the hydroxyl group of a polyester oligomer having a hydroxyl group at both terminals thereof, which is obtained by condensation of a polycarboxylic acid and a polyalcohol, with a (meth)acrylic acid. Alternatively, the prepolymer may also be obtained by esterifying the terminal hydroxyl group of an oligomer obtained by adding an alkylene oxide to a polycarboxylic acid, with a (meth)acrylic acid.

Epoxyacrylate prepolymers may be obtained, for example, by esterifying the oxirane ring of a bisphenol-type epoxy resin or a novolak-type epoxy resin having a relatively low molecular weight, with a (meth)acrylic acid. Urethane acrylate prepolymers may be obtained, for example, by esterifying a polyurethane oligomer having a hydroxyl group at both terminals thereof, which is obtained by reaction of a polyether polyol or a polyester polyol with a polyisocyanate, with a (meth)acrylic acid.

Polyol acrylate prepolymers may be obtained by esterifying the hydroxyl group of a polyether polyol with a (meth)acrylic acid.

One alone or two or more of these prepolymers may be used either singly or as combined, or may be combined with the above-mentioned polyfunctional (meth)acrylate monomer.

### (ii) Inorganic Fine Particles

The inorganic fine particles for use in the present invention are silica fine particles.

Among the silica fine particles, from the viewpoint of forming a strong bond with the active energy ray-curable compound (i), silica fine particles that have been surface-modified with an organic compound having a polymerizable unsaturated group capable of reacting with the active energy ray-curable compound are preferred.

Silica fine particles that have been surface-modified with an organic compound having a polymerizable unsaturated group can be obtained by reacting the silanol group in the surface of the silica fine particles with a polymerizable unsaturated group-containing organic compound that has a (meth)acryloyl group of a functional group capable of reacting with the silanol group.

In the present invention, the organic compound having a polymerizable unsaturated group that modifies the surface of silica fine particles is contained as the constituent element of the inorganic fine particles (ii), and is differentiated from the above-mentioned active energy ray-curable compound (i).

The polymerizable unsaturated group-containing compound that has a functional group capable of reacting with a silanol group is, for example, preferably a compound represented by the following general formula (1): 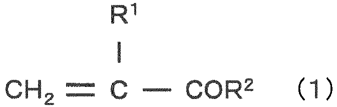 wherein R¹ represents a hydrogen atom or a methyl group, R² represents a halogen atom or a group represented by the following formula:

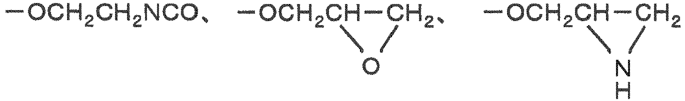

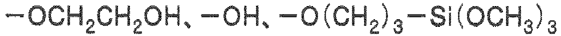

Examples of the organic compound include (meth)acrylic acid and derivatives thereof, such as (meth)acrylic acid, (meth)acrylic acid chloride, 2-isocyanatoethyl (meth)acrylate, glycidyl (meth)acrylate, 2,3-iminopropyl (meth)acrylate, 2-hydroxyethyl (meth)acrylate, (meth)acryloyloxypropyltrimethoxysilane, etc. One alone or two or more of these may be used either singly or as combined.

The content of the silica fine particles in the whole volume of the transparent resin layer B that contains inorganic fine particles is 20 to 70% by volume, more preferably 30 to 65% by volume, even more preferably 30 to 60% by volume. When the content of the silica fine particles falls within the range, increase in the surface roughness of the transparent conductive layer owing to heat history in transparent conductive layer lamination can be prevented, and increase in the surface roughness of the surface of the auxiliary electrode layer and the heat-resistant layer of the composite layer, as derived from curing shrinkage during resin curing, can be prevented. As described above, the inorganic fine particles are silica fine particles.

The thickness of the heat-resistant layer may be appropriately selected depending on the material for use in heat-resistant layer formation, the material and the thickness of the auxiliary electrode layer, and is generally 100 nm to 100 µm, preferably 1 to 50 µm, more preferably 2 to 20 µm. When the thickness of the heat-resistant layer falls within the range, increase in the surface roughness of the transparent conductive layer, as derived from the film for transparent conductive layer formation during transparent conductive layer lamination, can be prevented.

The ratio of the thickness t₁ of the heat-resistant layer to the thickness t₂ of the metal layer (auxiliary electrode layer) (t₁/t₂) is preferably 0.05 to 5.0, more preferably 0.10 to 4.0, even more preferably 0.10 to 2.0, especially preferably 0.10 to 1.0. When the ratio of the thickness t₁ of the heat-resistant layer to the thickness t₂ of the auxiliary electrode layer (t₁/t₂) falls within the range, increase in the surface roughness of the composite layer owing to curing shrinkage in heat-resistant layer formation can be prevented.

D90 (D90 is a particle size at cumulative 90 volume%) of the silica fine particles is preferably 200 nm or less, more preferably 50 nm or less, even more preferably 10 nm or less. When D90 falls within the range, favorably, light scattering by the fine particles can be prevented to improve optical properties.

The value of D90 of the silica fine particles, including the value of D90 of the silica fine particles used in Examples and Comparative Examples to be given hereinunder, was measured using a dynamic light-scattering particle size analyzer (manufactured by MicrotracBEL Corp., product name; Nanotrac Wave).

The arithmetic average roughness Ra, as defined in JIS-B0601-1994, of the surface including the interfacial level difference composed of the auxiliary electrode layer and the heat-resistant layer of the composite layer of the film for transparent conductive layer lamination of the present invention is preferably 40 nm or less, more preferably 20 nm or less, even more preferably 15 nm or less. When the arithmetic average roughness Ra falls within the range, the surface roughness of the laminated transparent conductive layer after lamination of a transparent conductive layer on the film for transparent conductive layer lamination can be controlled to fall within a preferred range to prevent occurrence of device failures owing to short circuit between electrodes in a device and to prevent reduction in device lifetime.

### (iii) Photopolymerization Initiator

The active energy ray-sensitive composition contains a photopolymerization initiator.

Examples of the photopolymerization initiator include benzoin, benzoin methyl ether, benzoin ethyl ether, benzoin isopropyl ether, benzoin n-butyl ether, benzoin isobutyl ether, acetophenone, dimethylaminoacetophenone, 2,2-dimethoxy-2-phenylacetophenone, 2,2-diethoxy-2-phenylacetophenone, 2-hydroxy-2-methyl-1-phenylpropan-1-one, 1-hydroycyclohexyl phenyl ketone, 2-methyl-1-[4-(methylthio)phenyl]-2-morpholino-propan-1-one, 4-(2-hydroxyethoxy)phenyl-2-(hydroxy-2-propyl) ketone, benzophenone, p-phenylbenzophenone, 4,4'-diethylaminobenzophenone, dicyclobenzophenone, 2-methylanthraquinone, 2-ethylanthraquinone, 2-tertiary-butylanthraquinone, 2-aminoanthraquinone, 2-methylthioxanthone, 2-ethylthioxanthone, 2-chlorothioxanthone, 2,4-dimethylthioxanthone, 2,4-diethylthioxanthone, benzyldimethyl ketal, acetophenone dimethyl ketal, p-dimethylaminobenzoate, etc. One alone or two or more kinds of these photopolymerization initiators may be used either singly or as combined.

Examples of commercial products of the active energy ray-sensitive composition containing the active energy ray-curable composition (i), the silica fine particles (ii) and the photopolymerization initiator (iii) include "Opstar Z7530", "Opstar Z7524", "Opstar TU4086" (product names, all by JSR Corporation), etc.

If desired, the active energy ray-sensitive composition may contain a UV absorbent.

The UV absorbent includes a benzotriazole-type UV absorbent, a hindered amine-type UV absorbent, a benzophenone-type UV absorbent, a triazine-type UV absorbent, etc.

One alone or two or more kinds of these UV absorbents may be used either singly or as combined. Among these, a radial-polymerizable UV absorbent having a radical-polymerizable double bond in the molecule is preferred.

The content of the UV absorbent, if any, is preferably 0.2 to 10 parts by mass, more preferably 0.5 to 7 parts by mass relative to 100 parts by mass of the total of the active energy ray-curable composition (i), the silica fine particles (ii) and the photopolymerization initiator (iii).

If desired, the active energy ray-sensitive composition may contain a light stabilizer.

The light stabilizer includes a hindered amine-type light stabilizer, a benzophenone-type light stabilizer, a benzotriazole-type light stabilizer, etc. One alone or two or more kinds of these light stabilizers may be used either singly or as combined.

The content of the light stabilizer, if any, is preferably 0.2 to 10 parts by mass, more preferably 0.5 to 7 parts by mass relative to 100 parts by mass of the total of the active energy ray-curable composition (i), the silica fine particles (ii) and the photopolymerization initiator (iii).

### (Transparent Resin Film Substrate)

Not specifically limited, the transparent resin film substrate for use in the present invention may be appropriately selected depending on the device and others to be used, and may be any one excellent in flexibility and transparency with no specific limitation. Examples of the substrate include polyimides, polyamides, polyamideimides, polyphenylene ethers, polyether ketones, polyether ether ketones, polyolefins, polyesters, polycarbonates, polysulfones, polyether sulfones, polyphenylene sulfides, polyarylates, acrylic resins, cycloolefin polymers, aromatic polymers, etc. Among these, the polyesters include polyethylene terephthalate (PET), polybutylene terephthalate, polyethylene naphthalate (PEN), polyarylates, etc. The cycloolefin polymers include norbornene polymers, monocyclic olefin polymers, cyclic conjugated diene polymers, vinyl-alicyclic hydrocarbon polymers, and hydrides thereof. Among these transparent resin film substrates, biaxially-stretched polyethylene terephthalate (PET) and polyethylene naphthalate (PEN) are especially preferred from the viewpoint of cost and heat resistance.

The thickness of the transparent film resin substrate is preferably 10 to 500 µm, more preferably 20 to 300 µm, even more preferably 25 to 100 µm. Falling within the range, the transparent resin film substrate can secure necessary mechanical strength and transparency.

### (Transparent Gas Barrier Layer)

Preferably, the film for transparent conductive layer lamination of the present invention is provided with a transparent gas barrier layer. For example, in Fig. 1, such a barrier layer is arranged between the transparent resin film substrate 2 and the composite layer 3, and prevents penetration of atmospheric water vapor that has passed through the transparent resin film substrate 2, and as a result, has a function of preventing water vapor penetration into the composite layer 3 and the transparent conductive layer 1b. Consequently, when a transparent conductive layer is laminated on the film for transparent conductive layer lamination to give a transparent conductive film, the resultant film can maintain the surface resistivity not suffering from degradation of the transparent conductive layer. In addition, when the film is used as a translucent electrode of an electronic device, degradation with time of the active layer and others inside the device can be prevented, and the device lifetime can be therefore prolonged.

The transparent gas barrier layer includes an inorganic vapor-deposition film such as a vapor-deposition film of an inorganic compound, a vapor-deposition film of a metal, as well as a layer formed by modifying a polymer compound-containing layer through ion injection thereinto.

Depending on the transparent resin film substrate, the gas barrier material and the number of the layers may be adequately selected and used.

### (Composite Layer)

The composite layer in the present invention is contained in a film for transparent conductive layer lamination, and is laminated on a transparent resin film substrate. The composite layer includes at least a transparent resin layer A, a metal layer having an opening, and the above-mentioned heat-resistant layer arranged in the opening. In the case where a transparent conductive layer is laminated on the film for transparent conductive layer lamination having a composite layer of the present invention to give a transparent conductive film, the composite layer has a function of preventing reduction in the resistance of the transparent conductive layer (reduction in the surface resistivity) and preventing increase in the surface roughness of the transparent conductive layer surface.

In Fig. 1, the composite layer 3 is formed on the transparent resin film substrate 2, and includes the transparent resin layer A4, the metal layer having an opening (auxiliary electrode layer) 6, and the inorganic fine particles-containing transparent resin layer B (heat-resistant layer) 5 arranged in the opening.

### <Metal Layer>

The metal layer is arranged so as to lower the surface resistivity of the transparent conductive layer when a transparent conductive layer is laminated on the film for transparent conductive layer lamination of the present invention to give a transparent conductive film. In general, in order not to lower the light transmittance of the transparent conductive layer, the layer is not a solid layer of a metal layer alone but is patterned to be the above-mentioned auxiliary electrode layer having an opening.

The material for forming the auxiliary electrode is not specifically limited, but when the layer is patterned according to a method of photolithography or the like, the material may be a elementary metal of gold, silver, copper, aluminum, nickel, platinum, etc.; a binary or ternary aluminum alloy such as aluminum-silicon, aluminum-copper, aluminum -titanium -palladium, etc. Among these materials, silver, copper and aluminum alloy are preferred, and from the viewpoint of cost, etchability, and corrosion resistance, copper and aluminum alloy are more preferred.

A conductive paste containing conductive fine particles may also be used. A conductive paste prepared by dispersing conductive fine particles such as metal fine particles, carbon fine particles, ruthenium oxide fine particles or the like in a solvent or in a solvent containing a binder may be used. The conductive paste may be printed and cured to form an auxiliary electrode layer.

The material of the metal fine particles is, from the viewpoint of conductivity, preferably silver, copper, gold or the like, and is preferably silver, copper, nickel, iron, cobalt or the like from the viewpoint of cost. In addition, from the viewpoint of corrosion resistance and chemical resistance, platinum, rhodium, ruthenium, palladium or the like is preferred. Carbon fine particles are inferior to metal fine particles in point of conductivity, but are inexpensive and are excellent in corrosion resistance and chemical resistance. Ruthenium oxide (RuO₂) fine particles are expensive as compared with carbon fine particles but are a conductive substance having excellent corrosion resistance, and therefore can be used as the auxiliary electrode layer.

The auxiliary electrode layer may be a single layer or may have a multilayer structure. The multilayer structure may be one formed by laminating layers of the same material, or may also be a multilayer structure formed by laminating layers of two or more different kinds of materials.

More preferably, the multilayer structure is a two-layer structure formed by laminating layers of different materials. For such a multilayer structure, for example, a silver pattern layer may be first formed and then a copper pattern layer may be formed thereon. The multilayer structure of the type is preferred as having improved corrosion resistance while maintaining high conductivity of silver.

The pattern of the auxiliary electrode layer in the present invention includes, though not specifically limited thereto, lattice-shaped, honeycomb-shaped, comb-shaped, stripe-shaped, linear, curved, waved (sign curved), polyangular network, circular network, oval network, irregular and the like patterns. Among these, lattice-shaped, honeycomb-shaped and comb-shaped patters are preferred.

The thickness of the auxiliary electrode layer is preferably 100 nm to 20 µm, more preferably 100 nm to 15 µm, even more preferably 100 nm to 10 µm.

The open area ratio of the opening of the pattern of the auxiliary electrode layer (the part where the auxiliary electrode layer is not formed) is, from the viewpoint of transparency (light transmittance), preferably 80% or more and less than 100%, more preferably 90% or more and less than 99%, even more preferably 93% or more and less than 98%. The open ratio is a ratio of the total surface of the opening to the area of the whole region where the pattern of the auxiliary electrode layer containing the opening is formed.

The line width of the auxiliary electrode layer is preferably 1 to 100 µm, more preferably 3 to 75 µm, even more preferably 5 to 60 µm. When the line width falls within the range, the open ratio can be favorably large enough to secure transmittance, and therefore a transparent conductive film having stable low resistance can be favorably obtained.

### <Transparent Resin Layer A>

The transparent resin layer A for use in the present invention is so arranged as to be kept in contact with the face composed of the auxiliary electrode layer and the heat-resistant layer, and has a function of mainly maintaining the mechanical strength of the whole composite layer.

For example, in Fig. 1, the transparent resin layer A4 is arranged between the face of the transparent resin film substrate 2 and the face composed of the auxiliary electrode layer 6 and the heat-resistant layer 5.

The transparent resin composition to form the transparent resin layer A in the present invention contains, for example, an active energy ray-curable compound, a thermoplastic resin, etc.

The active energy ray-curable compound includes the same as those for use in the above-mentioned heat-resistant layer.

Examples of the thermoplastic resin include polyolefin resins such as polyethylene, polypropylene, polybutene, etc.; (meth)acrylic resins, polyvinyl chloride resins, polystyrene resins, polyvinylidene chloride resins, saponified ethylene-vinyl acetate copolymers, polyvinyl alcohols, polycarbonate resins, fluororesins, polyvinyl acetate resins, acetal resins; polyester resins such as polyethylene terephthalate (PET), polyethylene naphthalate (PEN), polybutylene naphthalate (PBN), etc.; polyamide resins such as nylon 6, nylon 66, etc. One alone or two or more kinds of the above-mentioned resins may be used either singly or as combined. Among these, polyethylene, polypropylene, polystyrene, polyvinyl chloride and polyvinylidene chloride are preferred.

The thickness of the transparent resin layer A may be appropriately selected depending on the material and the thickness of the auxiliary electrode layer and the material and the thickness of the heat-resistant layer, etc., and may be generally 100 nm to 100 µm, preferably 1 to 50 µm, more preferably 5 to 25 µm.

### [Transparent Conductive Film]

The transparent conductive film of the present invention is, as described above, produced by laminating a transparent conductive layer on the composite layer of the film for transparent conductive layer lamination of the present invention. In Fig. 1, the transparent conductive film 1 is produced by laminating the transparent conductive layer 1b on the composite layer 3.

### (Transparent Conductive Layer)

As the transparent conductive layer, a transparent conductive oxide is preferably used. Specifically, the oxide includes indium-tin oxide (ITO), indium-zinc oxide (IZO), aluminum-zinc oxide (AZO), gallium-zinc oxide (GZO), indium-gallium-zinc oxide (IGZO), niobium oxide, titanium oxide, tin oxide, etc. One alone or a plurality of these may be used either singly or as combined. Among these, indium-tin oxide (ITO), gallium zinc oxide (GZO), indium-gallium-zinc oxide (IGZO) are preferred. From the viewpoint of transmittance, surface resistivity and stability, indium-tin oxide (ITO), indium-gallium-zinc oxide (IGZO) are more preferred, and from the viewpoint of wet heat resistance, indium-gallium-zinc oxide (IGZO) is especially preferred.

Further, as the transparent conductive layer, a conductive organic polymer is preferably used. The conductive organic polymer includes poly(3,4-ethylenedioxythiophene):poly(styrenesulfonic acid) [PEDOT:PSS], polythiophene, polyaniline, polypyrrole, etc. Among these, from the viewpoint of conductivity and transparency, poly(3,4-ethylenedioxythiophene):poly(styrenesulfonic acid) [PEDOT:PSS] and polythiophene are preferred, and from the viewpoint of conductivity and transparency, poly(3,4-ethylenedioxythiophene):poly(styrenesulfonic acid) [PEDOT:PSS] is more preferred.

The thickness of the transparent conductive layer is preferably 10 to 500 nm, more preferably 10 to 200 nm. The range is preferred since a thin film having both high transmittance and low surface resistivity can be obtained.

The arithmetic average thickness Ra, as defined according to JIS-B0601-1994, of the surface of the transparent conductive layer is preferably 40 nm or less, more preferably 35 nm or less, even more preferably 30 nm or less. When the arithmetic average roughness Ra falls within the range, occurrence of device failures owing to short circuit between electrodes in a device and reduction in device lifetime can be prevented.

The total light transmittance, as measured according to JIS K7361-1, of the transparent conductive layer is preferably 70% or more, more preferably 80% or more, even more preferably 90% or more.

Further, the surface resistivity of the transparent conductive monolayer is preferably 1000 (Ω/square) or less, more preferably 100 (Ω/square) or less.

In addition, the surface resistivity of the transparent conductive film having the auxiliary electrode layer of the present invention is preferably 5 (Q/square) or less, more preferably 1 (Ω/square) or less. When the surface resistivity is 5 (Ω/square) or less and when the transparent conductive film is used for the transparent electrode and the like of an electronic device that requires a large area, such as an organic thin-film solar cell, an organic EL lighting device, etc., the power loss (in an electronic device for power generation such as a solar cell or the like, the current density lowers in the site remoter from the collector electrode owing to the high electric resistivity of the transparent electrode layer to lower the conversion efficiency that determines the battery performance) and the characteristic fluctuation (in an electronic device for illumination such as an organic EL lighting device or the like, the current density lowers in the site remoter from the voltage application electrode owing to the high electric resistivity of the transparent electrode layer to cause brightness fluctuation or the like) in device operation (power collection and voltage application) can be improved.

### (Electronic Device)

The electronic device of the present invention is an electronic device, in which at least one of facing electrodes is formed of a transparent conductive film, and in which the transparent conductive film is the transparent conductive film of the present invention. Accordingly, the surface roughness of the transparent conductive layer surface of the transparent conductive film is controlled to be small, and therefore in the case where the transparent conductive film is incorporated in the electronic device, occurrence of device failures owing to short circuit between adjacent active layers to be caused by mechanical damage inside the device and reduction in device lifetime can be prevented. In addition, the surface resistivity of the transparent conductive layer can be reduced and the layer is flexible, and therefore the electronic device can be favorably used for organic thin film solar cells and organic EL lighting instruments that are required to have a large area.

### [Method for Producing Film for Transparent Conductive Layer Lamination]

The method for producing a film for transparent conductive layer lamination of the present invention is a method for producing a film for transparent conductive layer lamination that includes a transparent resin film substrate having laminated thereon a composite layer which at least includes a transparent resin layer A, a metal layer having an opening, and a transparent resin layer B containing silica fine particles provided in the opening, and the method includes the following steps (A) to (C):
(A) A step of forming the metal layer having an opening on a transfer substrate, forming the transparent resin layer B that contains inorganic fine particles in the opening, and further forming the transparent resin layer A to form a composite layer,
(B) A step of laminating the composite layer on the transparent resin film substrate, and
(C) A step of peeling the transfer substrate to transfer the smooth surface of the transfer substrate to the surface of the composite layer that includes the metal layer and the transparent resin layer B containing silica fine particles.

The method for producing the film for transparent conductive layer lamination of the present invention is described with reference to drawings.

Fig. 2 is an explanatory view showing one process example of the production method of the present invention in order of process steps, in which (a) is a cross-sectional view after formation of a metal layer 6 having an opening 7 on a transfer substrate 8, (b) is a cross-sectional view after formation of a transparent resin layer B5 containing silica fine particles in the opening 7 of the metal layer 6, (c) is a cross-sectional view after further formation of a transparent resin layer A4 on the surface of the metal layer 6 and the silica fine particles-containing transparent resin layer B5 to give a composite layer 3, (d) is a cross-sectional view showing a step of laminating the resultant composite layer 3 on a transparent resin film substrate 2, (e) is a cross-sectional view after peeling of the transfer substrate 8 from the side of the face not in contact with the transparent resin film substrate 2 of the composite layer 3 after lamination of the composite layer 3, thereby to transfer the smoothness of the face of the transfer substrate 8 to the composite layer 3.

### <(A) Composite Layer Forming Step>

The composite layer forming step is a step of forming a composite layer by forming, on a transfer substrate, a metal layer having an opening, a transparent resin layer B containing inorganic fine particles in the opening, and a transparent resin layer A on the surfaces thereof, and includes a step of forming a metal layer, a step of forming an silica fine particles-containing transparent resin layer B, and a step of forming a transparent resin layer A.

### (Step of Forming Metal Layer)

The step of forming a metal layer is a step of forming a pattern of a metal layer (auxiliary electrode layer) on a transfer substrate. In Fig. 2(a), this is a step of forming the metal layer (auxiliary electrode layer) 6 on the transfer substrate 8.

The transfer substrate for use in the present invention is formed of a substrate film, and preferably has a cured layer formed by curing a silicone resin composition thereon.

Though not specifically limited, examples of the substrate film include a polyester film of polyethylene terephthalate, polyethylene naphthalate or the like, a polyolefin film of polypropylene, polymethylpentene or the like, as well as a polycarbonate film, a polyvinyl acetate film, etc. Among these, a polyester film is preferred, and especially a biaxially-stretched polyethylene terephthalate film is preferred. The thickness of the substrate film is, from the viewpoint of mechanical strength and durability, preferably 10 µm to 500 µm, more preferably 25 µm to 300 µm, even more preferably 50 µm to 100 µm. The surface roughness of the substrate film is, from the viewpoint of the peelability of the transferred product and the surface roughness of the transferred product, preferably 30 nm or less as Ra, more preferably 20 nm or less, even more preferably 10 nm or less.

Regarding the method for forming the cured layer, a coating liquid containing a silicone resin composition and various optional additive components may be applied onto the above-mentioned substrate film, for example, according to a gravure coating method, a bar coating method, a spray coating method, a spin coating method or the like. In this step, for the purpose of controlling the viscosity of the coating liquid, a suitable organic solvent may be added to the liquid. Not specifically limited, various organic solvents may be used. For example, hydrocarbon compounds such as toluene, hexane, etc., as well as ethyl acetate, methyl ethyl ketone, and mixtures thereof may be used.

Regarding the method for forming the auxiliary electrode layer, there may be mentioned a method that includes providing an unpatterned solid metal layer on a transfer substrate, and then patterning it through known physical treatment or chemical treatment or a combination of the two mainly according to photolithography, or a direct patterning method for forming an auxiliary electrode layer according to an inkjet method, a screen printing method or the like.

The method for forming an unpatterned auxiliary electrode layer includes a dry process of a PVD method (physical vapor deposition method such as a vacuum evaporation method, a sputtering method, an ion plating method, etc., or a CVD method (chemical vapor deposition method) such as a thermal CVD method, an ALD method (atomic layer deposition method), etc.; as well as a wet process of various coating methods such as a dip coating method, a spin coating method, a spray coating method, a gravure coating method, a die coating method, a doctor blade coating method, etc., or electrodeposition, etc.; and a silver salt method, etc., and these may be appropriately selected depending on the material of the auxiliary electrode layer.

In the case where the auxiliary electrode layer is patterned according to a screen printing method or the like, a conductive paste containing conductive fine particles may be used. Needless-to-say, the patterning may also be carried out according to a method of photolithography, etc. From the viewpoint of process simplicity and of reducing cost and tact time, pattern printing with a conductive paste is preferably used.

As described above, the conductive paste to be used herein may be one prepared by dispersing conductive fine particles such as metal fine particles, carbon fine particles, ruthenium oxide fine particles or the like in a solvent or in a solvent containing a binder. The conductive paste is printed and cured to form an auxiliary electrode layer.

The material of the metal fine particles is as described above.

(Step of Forming Silica Fine Particles-Containing Transparent Resin Layer B) The step of forming the silica fine particles-containing transparent resin layer B is a step of laminating a silica fine particles-containing transparent resin layer B (heat-resistant layer) in the opening of the metal layer, and for example, in Fig. 2(b), a transparent resin composition having a silica fine particles-containing transparent resin is laminated in the opening 7 of the metal layer (auxiliary electrode layer) 6 on the transfer substrate 8 to form the silica fine particles-containing transparent resin layer B (heat-resistant layer) 5.

The method for forming the heat-resistant layer includes a thermal lamination method, a dip coating method, a spin coating method, a spray coating method, a gravure coating method, a die coating method, a doctor blade coating method, a Mayer bar coating method, etc.

In the case where the above-mentioned active energy ray-curable compound is used, for example, UV rays, electron beams and the like may be used in the method of irradiation with active energy radiations. The UV rays may be obtained from a high-pressure mercury lamp, a fusion H lamp, a xenon lamp, etc., and the light quantity is generally 100 to 1000 mJ/cm², and on the other hand, electron beams may be generated by an electron beam accelerator, and the irradiance level is generally 150 to 350 kV. Among the active energy rays, UV rays are especially preferred. In the case where electron beams are used, a cured film may be formed not requiring a photopolymerization initiator.

### (Step of Forming Transparent Resin Layer A)

The step of forming the transparent resin layer A is a step of laminating the transparent resin layer A on the face composed of the metal layer having an opening and the inorganic fine particles-containing transparent resin layer B arranged in the opening, and for example in Fig. 2(c), a transparent resin composition containing a transparent resin is laminated on the surface of the metal layer (auxiliary electrode layer) 6 and the silica fine particles-containing transparent resin layer B (heat-resistant layer) 5 on the transfer substrate 8 to form the transparent resin layer A4.

The method for forming the transparent resin layer A and the method for curing it are the same as those for the heat-resistant layer mentioned above.

In the case where a thermoplastic resin is used for the transparent resin layer A, thermal lamination is preferred as the production is simple. Thermal lamination may be carried out according to a known method, and regarding the lamination condition, in general, the heating temperature is 120 to 180°C and the pressure level is 0.1 to 25 MPa.

### <(B) Composite Layer Lamination Step>

The composite layer lamination step is a step of laminating the composite layer on the transfer substrate, as obtained in the composite layer formation step, to the side of a transparent film substrate, and for example, in Fig. 2(d), the transparent film substrate 2 and the composite layer 3 are arranged to face each other, and the composite layer 3 is laminated to the transparent film substrate 2.

### <(C) Smooth Surface Transfer Step>

The smooth surface transfer step is a step of peeling the face composed of the transfer substrate and the composite layer, thus transferring the smooth surface of the transfer substrate to the face composed of the auxiliary electrode layer and the heat-resistant layer of the composite layer. For example, as shown in Fig. 2(e), the transfer substrate 8 and the composite layer 3 are peeled via the interface therebetween to transfer the smoothness of the face of the transfer substrate 8 to the face of the composite layer 3, thereby forming a face of the auxiliary electrode layer and the heat-resistant layer having a small surface roughness and a small level difference. The transferring method and the peeling method are not specifically limited and may be carried out according to known methods.

The film for transparent conductive layer lamination obtained according to the above-mentioned production method is further processed in the following transparent conductive layer forming step to produce a transparent conductive film.

### <Transparent Conductive Layer Forming Step>

The transparent conductive layer forming step is a step of laminating a transparent conductive layer on the side of the face of the auxiliary electrode layer and the heat-resistant layer of the composite layer of the film for transparent conductive layer lamination obtained in the previous step. For example, in Fig. 2(f), a transparent conductive oxide or a conductive organic polymer is laminated on the composite layer 3 to form the transparent conductive layer 1b.

The method for forming the transparent conductive layer includes PVD (physical vapor deposition method) such as a vacuum evaporation method, a sputtering method, an ion plating method, etc., or CVD (chemical vapor deposition method) such as thermal CVD, atomic layer deposition (ALD), etc. After lamination according to the above-mentioned method, if desired, the layer maybe heat-treated within a range not having any negative influence on the other laminates, thereby forming a transparent conductive layer having a more excellent surface resistivity.

For the transparent conductive layer, a transparent conductive layer forming coating liquid may be used. For the method for forming the transparent conductive layer, a dip coating method, a spin coating method, a spray coating method, a gravure coating method, a die coating method, a doctor blade coating method and the like are employable. After coated and dried according to the above-mentioned method, if desired, the layer may be cured through heating treatment or UV irradiation treatment within a range not having any negative influence on the other laminates, thereby forming a transparent conductive layer having a more excellent surface resistivity.

The transparent conductive layer forming coating liquid for use in the present invention contains a solvent and conductive oxide fine particles dispersed in the solvent. As the conductive oxide fine particles, indium-tin oxide (ITO), indium-zinc oxide (IZO), aluminum-zinc oxide (AZO), gallium-zinc oxide (GZO), indium-gallium-zinc oxide (IGZO), niobium oxide, titanium oxide, tin oxide and the like that have been listed hereinabove for the above-mentioned transparent conductive layer materials and have transparency and conductivity can be employed. The mean particle size of the conductive oxide fine particles is preferably 10 to 100 nm. The range is preferred as securing high transparency and high conductivity.

A binder may be added to the transparent conductive layer forming coating liquid for increasing the film strength in the form of a single layer. For the binder, both or any one of an organic binder and an inorganic binder may be used and may be appropriately selected in consideration of the influence thereof on the transparent resin layer B and the auxiliary electrode layer which have a face to be applied.

Though not specifically limited, the organic binder may be appropriately selected from thermoplastic resins, thermosetting resins, UV-curable resins, electron beam-curable resins, etc. Examples of the thermoplastic resins include acrylic resins, polyolefin resins, PET resins, polyvinyl alcohol resins, etc.; the thermosetting resins include epoxy resins, etc.; the UV-curable resins include resins containing various oligomers or monomers and a photopolymerization initiator, etc.; the electron beam-curable resins include resins containing various oligomers or monomers, etc.

Also though not specifically limited, the inorganic binder includes a binder containing silica sol as the main component. The inorganic binder may contain magnesium fluoride fine particles, alumina sol, zirconia sol, titania sol, etc., as well as silica sol modified with an organic functional group.

According to the production method of the present invention, there can be produced a film for transparent conductive layer lamination having a face of an auxiliary electrode layer and a heat-resistant layer, and having a high heat resistance and small surface roughness. Further, when a transparent conductive layer is laminated on the face, there can be produced a transparent conductive film having a low surface resistivity and protected from occurrence of device characteristic failure and from reduction in device lifetime owing to short circuit between electrodes in a device.

### Examples

Next, the present invention is described in more detail with reference to Examples, but the present invention is not whatsoever restricted by these Examples.

The surface roughness of the film for transparent conductive layer lamination and the transparent conductive film, and the surface resistivity of the transparent conductive film, produced in Examples and Comparative Examples, were evaluated according to the methods mentioned below.

### (a) Interfacial Level Difference, Surface Roughness

The surface of formed of the auxiliary electrode layer and the inorganic fine particles-containing transparent resin layer B of the composite layer of the film for transparent conductive layer lamination (after transfer of smooth face of transfer substrate), and the surface laminated with a transparent conductive layer were analyzed using an optical interferometric surface roughness meter (manufactured by Veeco Instruments, Inc., Model: Wyko NT1100) to measure the arithmetic average roughness Ra thereof, as defined in JIS-B0601-1994, to thereby evaluate the surface roughness including the level difference between the interfacial sites of different layers.

### (b) Surface Resistivity of Transparent Conductive Film

Using a low resistivity meter (manufactured by Mitsubishi Chemical Analytech Co., Ltd., device name: Loresta AX MCP-T370), the surface resistivity (Q/square) of the transparent conductive film was measured in an environment at 25°C and 50% RH.

### (Example 1)

Using a screen printing device (manufactured by Micro Tech Co., device name: MT-320TV), a conductive paste (manufactured by Mitsuboshi Belting Ltd., product name: EC-264) was printed on a transfer substrate (manufactured by Lintec Corporation, product name: PLD8030), and heated and dried to form an auxiliary electrode layer of a lattice-shaped metal thin wire pattern having a thickness of 6 µm, a line width of 50 µm and a pitch of 2,000 µm.

Next, using a bar coater, an acrylic resin composition A*¹ (manufactured by JSR Corporation, product name: Opstar Z7530) was applied as an inorganic fine particles-containing transparent resin B, that is, a heat-resistant layer to provide a heat-resistant layer in the opening of the auxiliary electrode layer, and further, as a transparent resin layer A, an acrylic resin composition B*² (manufactured by Toagosei Co., Ltd., product name: UVX-6125) was applied using a bar coater to provide a transparent resin layer A on the auxiliary electrode layer and the heat-resistant layer, thereby forming a composite layer formed of the auxiliary electrode layer, the heat-resistant layer and the transparent resin layer A (at this point, the heat-resistant layer and the transparent resin layer A were uncured). With that, the face of the composite layer opposite to the other face thereto to be in contact with a transfer substrate was laminated with the face of the transparent gas barrier layer opposite to the other face thereof to be in contact the transparent resin film substrate of a transparent resin film substrate having a transparent gas barrier layer to be mentioned below, and this was irradiated with UV rays from the side of the transparent resin film substrate having the transparent gas barrier layer to thereby cure the heat-resistant layer and the transparent resin layer A in the composite layer (thickness of the heat-resistant layer after curing: 2 µm, thickness of the transparent resin layer A after curing: 30 µm). Finally, the transfer substrate was peeled from the composite layer to produce a film for transparent conductive layer lamination, in which the composite layer formed of the metal layer having an opening (auxiliary electrode layer), the heat-resistant layer and the transparent resin layer A was laminated on the transparent resin film substrate via the transparent gas barrier layer.
*1: Prepared by mixing an active energy ray-curable resin, dipentaerythritol hexaacrylate (DPHA; density: 1.25 g/cm³) and inorganic fine particles of reactive silica (referred to as silica 1; density: 2.1 g/cm³; D90: 5.23 nm) in a ratio by mass of 40/60, in which the content of the inorganic fine particles was 49% by volume, the photopolymerization initiator was 3% by mass, the solid concentration was 19% by mass, and the solvent was methyl ethyl ketone.
*2: Acrylic resin composition B (using acrylic active energy ray-curable resin).

Coating liquid viscosity: 380 mPa·sec
Solid concentration in coating liquid: 100%
Curing shrinkage: 8.9%
Glass transition temperature measured with a dynamic viscoelastometer: (manufactured by TA Instruments, machine name "DMA Q800"): 148°C
Storage elastic modulus measured with a dynamic viscoelastometer at 23°C in a tensile mode, at a frequency of 11 Hz, and at a heating rate of 3°C/min: 2.2 GPa
Storage elastic modulus measured with a dynamic viscoelastometer at 100°C in a tensile mode, at a frequency of 11 Hz, and at a heating rate of 3°C/min: 0.6 GPa

### <Formation of Transparent Gas Barrier Layer>

A primer layer forming solution mentioned below was applied onto a transparent resin film substrate (manufactured by Teijin DuPont Film Ltd., PENQ65HWA) according to a bar coating method, then dried under heat at 70°C for 1 minute, and subjected to UV irradiation using a UV irradiation line (manufactured by Fusion UV Systems Japan, high-pressure mercury lamp: integrated light quantity: 100 mJ/cm², peak intensity: 1.466 W, line speed: 20 m/min, number of passes: two) to form a primer layer having a thickness of 1 µm. On the resultant primer layer, a perhydropolysilazane-containing liquid (manufactured by AZ Electronic Materials Japan Co., Ltd., product name: AZNL110A-20) was applied according to a spin coating method, and the resultant coating film was heated at 120°C for 2 minutes to form a perhydropolysilazane layer having a thickness of 150 nm. Further, argon (Ar) was injected into the resultant perhydropolysilazane layer in a mode of plasma ion injection under the condition mentioned below to give a plasma ion-injected perhydropolysilazane layer (hereinafter referred to as "inorganic layer A").

Next, on the inorganic layer A, a silicon oxynitride layer (inorganic layer B) was formed in the same manner as that for the inorganic layer A, thereby forming a transparent gas barrier layer as the second layer on the transparent resin film substrate.

### (Primer Layer Forming Solution)

20 parts by mass of dipentaerythritol hexaacrylate (manufactured by Shin-Nakamura Chemical Co., Ltd., product name: A-DPH) was dissolved in 100 parts by mass of methyl isobutyl ketone, and then a photopolymerization initiator (manufactured by BASF, product name: Irgacure 127) was added thereto to be in an amount of 3% by mass relative to the solid content, thereby preparing a primer layer forming solution.

Plasma ion injection was carried out under the following injection condition using the following apparatus.

### <Plasma Ion Injection Apparatus>

RF power source: model number "RF56000", manufactured by JEOL Ltd.

High-voltage pulse power source: "PV-3-HSHV-0835", manufactured by Cup-Kurita Co., Ltd.

### <Plasma Ion Injection Condition>

Plasma forming gas: Ar
Gas flow rate: 100 sccm
Duty ratio: 0.5%
Repeating frequency: 1,000 Hz
Applied voltage: -6 kV
RF power source: frequency 13.56 MHz, applied power 1,000 W
Chamber inner pressure: 0.2 Pa
Pulse width: 5 sec
Processing time (ion injection tine): 200 sec
Transportation velocity: 0.2 m/min

Further, using a sputtering apparatus (manufactured by Ulvac Inc., apparatus name: ISP-4000S-C), an indium-tin oxide (ITO, 50 nm) was laminated on the surface of the composite layer of the resultant film for transparent conductive layer lamination, thereby producing a transparent conductive film.

The arithmetic average roughness Ra of the surface on the composite layer side of the produced film for transparent conductive layer lamination and the surface on the transparent conductive layer side of the transparent conductive film, and the surface resistivity of the transparent conductive film were determined. The results are shown in Table 1.

### (Example 2)

A film for transparent conductive layer lamination and a transparent conductive film were produced in the same manner as in Example 1, except that the thickness of the heat-resistant layer in Example 1 was changed to 4 µm. The arithmetic average roughness Ra of the surface on the composite layer side of the produced film for transparent conductive layer lamination and the surface on the transparent conductive layer side of the transparent conductive film, and the surface resistivity of the transparent conductive film were determined. The results are shown in Table 1.

### (Example 3)

A film for transparent conductive layer lamination and a transparent conductive film were produced in the same manner as in Example 1, except that the thickness of the heat-resistant layer in Example 1 was changed to 19 µm. The arithmetic average roughness Ra of the surface on the composite layer side of the produced film for transparent conductive layer lamination and the surface on the transparent conductive layer side of the transparent conductive film, and the surface resistivity of the transparent conductive film were determined. The results are shown in Table 1.

### (Example 4)

A film for transparent conductive layer lamination and a transparent conductive film were produced in the same manner as in Example 1, except that, in Example 1, the inorganic fine particles-containing acrylic resin composition A used in forming the heat-resistant layer was changed to an acrylic resin composition C*³ containing inorganic fine particles (manufactured by Nissan Chemical Industries, Ltd., product name: MIBK-AC-2140Z), the thickness was changed to 3 µm, and the content of the inorganic fine particles was changed to 30% by volume. The arithmetic average roughness Ra of the surface on the composite layer side of the produced film for transparent conductive layer lamination and the surface on the transparent conductive layer side of the transparent conductive film, and the surface resistivity of the transparent conductive film were determined. The results are shown in Table 1.
*3: Prepared by mixing an active energy ray-curable resin, dipentaerythritol hexaacrylate (DPHA; density: 1.25 g/cm³) and inorganic fine particles of reactive silica (MIBK-AC-2140Z; referred to as silica 2; density: 2.1 g/cm³; D90: 5.59 nm) in a ratio by mass of 56/44, in which the content of the inorganic fine particles was 30% by volume, the photopolymerization initiator was 3% by mass, the solid concentration was 50% by mass, and the solvent was methyl isobutyl ketone.

### (Example 5)

A film for transparent conductive layer lamination and a transparent conductive film were produced in the same manner as in Example 4, except that, in Example 4, the content of the inorganic fine particles was changed from 30% by volume to 40% by volume. The arithmetic average roughness Ra of the surface on the composite layer side of the produced film for transparent conductive layer lamination and the surface on the transparent conductive layer side of the transparent conductive film, and the surface resistivity of the transparent conductive film were determined. The results are shown in Table 1.

### (Example 6)

A film for transparent conductive layer lamination and a transparent conductive film were produced in the same manner as in Example 4, except that, in Example 4, the content of the inorganic fine particles was changed from 30% by volume to 60% by volume. The arithmetic average roughness Ra of the surface on the composite layer side of the produced film for transparent conductive layer lamination and the surface on the transparent conductive layer side of the transparent conductive film, and the surface resistivity of the transparent conductive film were determined. The results are shown in Table 1.

### (Comparative Example 1)

A film for transparent conductive layer lamination and a transparent conductive film were produced in the same manner as in Example 1, except that, in Example 1, the heat-resistant layer was omitted. The arithmetic average roughness Ra of the surface on the composite layer side of the produced film for transparent conductive layer lamination and the surface on the transparent conductive layer side of the transparent conductive film, and the surface resistivity of the transparent conductive film were determined. The results are shown in Table 1.

### (Comparative Example 2)

A film for transparent conductive layer lamination and a transparent conductive film were produced in the same manner as in Example 4, except that, in Example 4, the heat-resistant layer did not contain the inorganic fine particles (accordingly, the layer was not a heat-resistant layer). The arithmetic average roughness Ra of the surface on the composite layer side of the produced film for transparent conductive layer lamination and the surface on the transparent conductive layer side of the transparent conductive film, and the surface resistivity of the transparent conductive film were determined. The results are shown in Table 1.

**Table 1**

| | Inorganic Fine Particles-Containing Transparent Resin Layer B (heat-resistant layer) | | | | Transparent Resin Layer A | | (Thickness of Heat-Resistant Layer)/ (Thickness of Auxiliary Electrode Layer) | Arithmetic Average Roughness Ra | | Transparent Conductive Film |
|---|---|---|---|---|---|---|---|---|---|---|
| | Constitution of Heat-Resistant Layer | Content of Inorganic Fine Particles | | Thickness (µm) | Constitution of Transparent Resin Layer A | Thickness (µm) | | | | |
| | | Silica 1 (vol%) | Silica 2 (vol%) | | | | | Before lamination (nm) | After lamination (nm) | Surface Resistivity (Ω/square) |
| Example 1 | Acrylic Resin Composition A (Opstar Z7530) | 49 | - | 2 | Acrylic Resin Composition B (UVX-6125) | 30 | 0.33 | 15 | 24 | 0.8 |
| Example 2 | Acrylic Resin Composition A (Opstar Z7530) | 49 | - | 4 | Acrylic Resin Composition B (UVX-6125) | 30 | 0.67 | 11 | 26 | 0.8 |
| Example 3 | Acrylic Resin Composition A (Opstar Z7530) | 49 | - | 19 | Acrylic Resin Composition B (UVX-6125) | 30 | 3.17 | 13 | 34 | 0.8 |
| Example 4 | Acrylic Resin Composition C (DPHA + MIBK-AC-2140Z) | - | 30 | 3 | Acrylic Resin Composition B (UVX-6125) | 30 | 0.50 | 13 | 36 | 0.8 |
| Example 5 | Acrylic Resin Composition C (DPHA + MIBK-AC-2140Z) | - | 40 | 3 | Acrylic Resin Composition B (UVX-6125) | 30 | 0.50 | 12 | 37 | 0.8 |
| Example 6 | Acrylic Resin Composition C (DPHA + MIBK-AC-2140Z) | - | 60 | 3 | Acrylic Resin Composition B (UVX-6125) | 30 | 0.50 | 9 | 38 | 0.8 |
| Comparative Example 1 | No Heat-Resistant Layer | - | - | - | Acrylic Resin Composition B (UVX-6125) | 30 | - | 47 | 82 | 0.8 |
| Comparative Example 2 | No Inorganic Fine Particles (DPHA alone) | - | - | 3 | Acrylic Resin Composition B (UVX-6125) | 30 | - | 16 | 49 | 0.8 |

As obvious from Table 1, Examples 1, 2 and 3 were excellent as compared with Comparative Example 1 having no heat-resistant layer, in that the value of the arithmetic average roughness Ra before ITO lamination in the former was small. In addition, it is known that the increase in the arithmetic average roughness Ra before and after ITO lamination was suppressed and the excellent smoothness was maintained.

Examples 4, 5 and 6 were excellent as compared with Comparative Example 2 using the transparent resin layer not containing inorganic fine particles in the heat-resistant layer, in that the value of the arithmetic average roughness Ra before ITO lamination in the former was small. In addition, it is known that the increase in the arithmetic average roughness Ra before and after ITO lamination was suppressed and the excellent smoothness was maintained.

### Industrial Applicability

The film for transparent conductive layer lamination of the present invention has high heat resistance, and the smoothness of the surface containing the auxiliary electrode layer therein is excellent, and accordingly, the smoothness of the surface of the transparent conductive film produced by laminating a transparent conductive layer on the film for transparent conductive layer lamination is also excellent. Consequently, in the present invention, there can be obtained a transparent conductive film having a low surface resistivity and protected from occurrence of device characteristic failure and from reduction in device lifetime owing to short circuit between electrodes in a device. For example, the present invention is applicable to an electronic device in which at least one transparent conductive film of electrodes facing each other is formed of the transparent conductive film of the present invention (organic thin film solar cell, organic EL lighting device), etc.

### Reference Signs List

1: Transparent Conductive Film
1a: Film for Transparent Conductive Film Lamination
1b: Transparent Conductive Film
2: Transparent Resin Film Substrate
3: Composite Layer
4: Transparent Resin Layer A
5: Inorganic Fine Particles-Containing Transparent Resin Layer B (heat-resistant layer)
6: Metal Layer (auxiliary electrode layer)
7: Opening
8: Transfer substrate

## Claims

1. A film for transparent conductive layer lamination, comprising a transparent resin film substrate (2) having laminated thereon a composite layer (3) which at least includes a transparent resin layer A (4), a metal layer (6) having an opening (7), and a transparent resin layer B (5) containing inorganic fine particles provided in the opening (7), whereby the metal layer (6) and the transparent resin layer B (5) containing inorganic fine particles are composing the face of the composite layer (3) on the side opposite to the face of the transparent resin film substrate (2) side,
wherein the content of the inorganic fine particles in the total volume of the transparent resin layer B (5) containing inorganic fine particles is from 20 to 70% by volume, and
wherein the inorganic fine particles are silica fine particles.

2. The film for transparent conductive layer lamination according to claim 1, wherein the thickness of the transparent resin layer B (5) containing inorganic fine particles is from 100 nm to 100 µm.

3. The film for transparent conductive layer lamination according to claim 1 or 2, wherein the cumulative 90% volume-particle diameter of the inorganic fine particles (D90) as measured using a dynamic light-scattering particle size analyzer is 200 nm or less.

4. The film for transparent conductive layer lamination according to claim 1, wherein the arithmetic average roughness Ra, as defined in JIS-B0601-1994, of the surface that includes the interfacial level difference formed of the metal layer (6) and the transparent resin layer B (5) containing inorganic fine particles of the composite layer (3) is 40 nm or less.

5. The film for transparent conductive layer lamination according to claim 1, wherein the film for transparent conductive layer lamination further comprises a gas barrier layer.

6. A transparent conductive film comprising a transparent conductive layer laminated on the composite layer (3) of the film for transparent conductive layer lamination of any one of claims 1 to 5.

7. The transparent conductive film according to claim 6, wherein the arithmetic average roughness Ra, as defined in JIS-B0601-1994, of the surface of the transparent conductive layer is 40 nm or less.

8. An electronic device wherein at least one of the opposite electrodes therein is formed of a transparent conductive film, and wherein the transparent conductive film is the transparent conductive film of claim 6 or 7.

9. The electronic device according to claim 8, wherein the electronic device is an organic thin-film solar cell or an organic EL lighting device.

10. A method for producing a film for transparent conductive layer lamination that includes a transparent resin film substrate (2) having laminated thereon a composite layer (3) which at least includes a transparent resin layer A (4), a metal layer (6) having an opening (7), and a transparent resin layer B (5) containing inorganic fine particles provided in the opening (7), the method comprising the following steps (A) to (C):
(A) a step of forming the metal layer (6) having an opening (7) on a transfer substrate (8), forming the transparent resin layer B (5) that contains inorganic fine particles in the opening (7), and further forming the transparent resin layer A (4) to form a composite layer (3),
(B) a step of laminating the composite layer (3) on the transparent resin film substrate (2), and
(C) a step of peeling the transfer substrate (8) to transfer the smooth surface of the transfer substrate (8) to the face of the composite layer (3) which is composed of the metal layer (6) and the transparent resin layer B (5) containing inorganic fine particles,
wherein the content of the inorganic fine particles in the total volume of the transparent resin layer B (5) containing inorganic fine particles is from 20 to 70% by volume, and
wherein the inorganic fine particles are silica fine particles.

11. The method for producing a transparent conductive film according to claim 10, comprising a step of further laminating a transparent conductive layer on the composite layer (3) of the film for transparent conductive layer lamination.

## Patentansprüche

1. Folie für eine transparente leitfähige Schichtlaminierung, umfassend ein transparentes Harzfoliensubstrat (2), auf das eine Verbundschicht (3) laminiert ist, die mindestens umfasst eine transparente Harzschicht A (4), eine Metallschicht (6) mit einer Öffnung (7) und eine transparente Harzschicht B (5), die anorganische Feinpartikel enthält, die in der Öffnung (7) vorgesehen sind, wobei die Metallschicht (6) und die transparente Harzschicht B (5), die anorganische Feinpartikel enthält, die Fläche der Verbundschicht (3) auf der Seite bilden, die der Fläche des transparenten Harzfilmsubstrats (2) gegenüberliegt,
wobei der Anteil der anorganischen Feinteilchen am Gesamtvolumen der anorganische Feinteilchen enthaltenden transparenten Harzschicht B (5) 20 bis 70 Vol.-% beträgt, und
wobei es sich bei den anorganischen Feinpartikeln um feine Kieselsäurepartikel handelt.

2. Folie für eine transparente leitfähige Schichtlaminierung nach Anspruch 1, wobei die Dicke der transparenten Harzschicht B (5), die anorganische Feinpartikel enthält, 100 nm bis 100 µm beträgt.

3. Folie für eine transparente leitfähige Schichtlaminierung nach Anspruch 1 oder 2, wobei der kumulative 90%ige Volumen-Teilchendurchmesser der anorganischen Feinteilchen (D90), gemessen mit einem dynamischen Lichtstreuungs-Teilchengrößenanalysator, 200 nm oder weniger beträgt.

4. Folie für eine transparente leitfähige Schichtlaminierung nach Anspruch 1, wobei die arithmetische Durchschnittsrauhigkeit Ra der Oberfläche, welche die Grenzflächenniveaudifferenz, die auf der Metallschicht (6) gebildet wird, und die transparente Harzschicht B (5), die anorganische Feinpartikel der Verbundschicht (3) enthält, umfasst, 40 nm oder weniger beträgt.

5. Folie für die transparente leitfähige Schichtlaminierung nach Anspruch 1, wobei die Folie für die transparente leitfähige Schichtlaminierung außerdem eine Gassperrschicht umfasst.

6. Transparente leitfähige Folie mit einer transparenten leitfähigen Schicht, die auf die Verbundschicht (3) der Folie zur Laminierung der transparenten leitfähigen Schicht nach einem der Ansprüche 1 bis 5 laminiert ist.

7. Transparente leitfähige Folie nach Anspruch 6, wobei der arithmetische Mittelwert der Rauhigkeit Ra der Oberfläche der transparenten leitfähigen Schicht, wie in JIS-B0601-1994 definiert, 40 nm oder weniger beträgt.

8. Elektronische Vorrichtung, bei der mindestens eine der gegenüberliegenden Elektroden aus einem transparenten leitfähigen Film gebildet ist, und wobei der transparente leitfähige Film gemäß Anspruch 6 oder 7 ist.

9. Elektronische Vorrichtung nach Anspruch 8, wobei die elektronische Vorrichtung eine organische Dünnschichtsolarzelle oder eine organische EL-Beleuchtungsvorrichtung ist.

10. Verfahren zur Herstellung eines Films für eine transparente leitfähige Schichtlaminierung, das ein transparentes Harzfilmsubstrat (2) einschließt, auf das eine Verbundschicht (3) laminiert ist, die mindestens eine transparente Harzschicht A (4), eine Metallschicht (6) mit einer Öffnung (7) und eine transparente Harzschicht B (5) einschließt, die anorganische feine Teilchen enthält, die in der Öffnung (7) vorgesehen sind, wobei das Verfahren die folgenden Schritte (A) bis (C) umfasst:
(A) einen Schritt des Bildens der Metallschicht (6) mit einer Öffnung (7) auf einem Transfersubstrat (8), des Bildens der transparenten Harzschicht B (5), die anorganische feine Teilchen in der Öffnung (7) enthält, und des weiteren Bildens der transparenten Harzschicht A (4), um eine Verbundschicht (3) zu bilden,
(B) einen Schritt des Laminierens der Verbundschicht (3) auf das transparente Harzfilmsubstrat (2), und
(C) einen Schritt des Abziehens des Transfersubstrats (8), um die glatte Oberfläche des Transfersubstrats (8) auf die Fläche der Verbundschicht (3) zu übertragen, die aus der Metallschicht (6) und der transparenten Harzschicht B (5) besteht, die anorganische Feinpartikel enthält,
wobei der Anteil der anorganischen Feinteilchen am Gesamtvolumen der anorganische Feinteilchen enthaltenden transparenten Harzschicht B (5) 20 bis 70 Vol.-% beträgt, und
wobei es sich bei den anorganischen Feinpartikeln um feine Kieselsäurepartikel handelt.

11. Verfahren zur Herstellung einer transparenten leitfähigen Folie nach Anspruch 10, umfassend einen Schritt des weiteren Laminierens einer transparenten leitfähigen Schicht auf die Verbundschicht (3) der Folie zur Laminierung der transparenten leitfähigen Schicht.

## Revendications

1. Film pour stratification de couche conductrice transparente, comprenant un substrat de film de résine transparente (2) ayant une couche composite stratifiée là-dessus (3) qui inclue au moins une couche de résine transparente A (4), une couche de métal (6) ayant une ouverture (7), et une couche de résine transparente B (5) contenant des particules fines inorganiques fournies dans l'ouverture (7), et une couche de résine transparente B (5) contenant des particules fines inorganiques dans l'ouverture (7), par laquelle la couche de métal (6) et la couche de résine transparente B (5) contenant des particules fines inorganiques composent la face de la couche composite (3) du côté opposé à la face du substrat de film de résine transparente (2),
dans lequel la teneur en particules fines inorganiques dans le volume total de la couche de résine transparente B (5) contenant des particules fines inorganiques est de 20 à 70 % en volume, et
dans lequel les particules fines inorganiques sont des particules fines de silice.

2. Film pour stratification de couche conductrice transparente selon la revendication 1, dans lequel l'épaisseur de la couche de résine transparente B (5) contenant des particules fines inorganiques est de 100 nm à 100 µm.

3. Film pour stratification de couche conductrice transparente selon la revendication 1 ou 2, dans lequel le diamètre cumulé à 90 % du volume des particules fines inorganiques (D90), mesuré à l'aide d'un analyseur de taille de particules par diffusion dynamique de la lumière, est de 200 nm ou moins.

4. Film pour stratification de couche conductrice transparente selon la revendication 1, dans lequel la rugosité moyenne arithmétique Ra, comme définie dans JIS-B0601-1994, de la surface qui inclue la différence de niveau interfaciale formée de la couche métallique (6) et de la couche de résine transparente B (5) contenant des particules fines inorganiques de la couche composite (3) est de 40 nm ou moins.

5. Film pour stratification de couche conductrice transparente selon la revendication 1, dans lequel le film pour stratification de couche conductrice transparente comprend en outre une couche de barrière au gaz.

6. Film conducteur transparent comprenant une couche conductrice transparente stratifiée sur la couche composite (3) du film pour stratification de couche conductrice transparente de l'une quelconque des revendications 1 à 5.

7. Film conducteur transparent selon la revendication 6, dans lequel la rugosité moyenne arithmétique Ra, comme définie dans la norme JIS-BO601-1994, de la surface de la couche conductrice transparente est de 40 nm ou moins.

8. Dispositif électronique dans lequel au moins une des électrodes opposées là-dedans est formée d'un film conducteur transparent, et dans lequel le film conducteur transparent est le film conducteur transparent de la revendication 6 ou 7.

9. Dispositif électronique selon la revendication 8, dans lequel le dispositif électronique est une cellule solaire organique à couche mince ou un dispositif d'éclairage EL organique.

10. Procédé de fabrication d'un film pour stratification de couche conductrice transparente qui inclue un substrat de film de résine transparente (2) ayant stratifiée là-dessus une couche composite (3) qui comprend au moins une couche de résine transparente A (4), une couche métallique (6) ayant une ouverture (7), et une couche de résine transparente B (5) contenant des particules fines inorganiques fournies dans l'ouverture (7), le procédé comprenant les étapes suivantes (A) à (C) :
(A) une étape de formation de la couche métallique (6) ayant une ouverture (7) sur un substrat de transfert (8), formant la couche de résine transparente B (5) qui contient des particules fines inorganiques dans l'ouverture (7), et formant en outre la couche de résine transparente A (4) pour former une couche composite (3),
(B) une étape de stratification de la couche composite (3) sur le substrat de film de résine transparent (2), et
(C) une étape de pelage du substrat de transfert (8) pour transférer la surface lisse du substrat de transfert (8) sur la face de la couche composite (3) qui est composée de la couche métallique (6) et de la couche de résine transparente B (5) contenant des particules fines inorganiques,
dans lequel la teneur en particules fines inorganiques dans le volume total de la couche de résine transparente B (5) contenant des particules fines inorganiques est de 20 à 70 % en volume, et
dans lequel les particules fines inorganiques sont des particules fines de silice.

11. Procédé de fabrication d'un film conducteur transparent selon la revendication 10, comprenant une étape de stratification supplémentaire d'une couche conductrice transparente sur la couche composite (3) du film pour la stratification de couche conductrice transparente.
